# EUROPEAN PATENT APPLICATION

(11) **EP 4 589 722 A1**
(43) Date of publication of application: **23.07.2025**
(21) Application number: 24197794.1
(22) Date of filing: 02.09.2024
(51) Int. Cl.: H01M 10/48, A62C 3/16, H01M 50/204, H01M 50/251

(54) **ENERGY STORAGE SYSTEM**

(30) Priority: 19.01.2024 KR 20240008593
(71) Applicant: SAMSUNG SDI CO., LTD., Giheung-gu Yongin-si, Gyeonggi-do 17084 (KR)
(72) Inventor: HWANG, Yu Sik, 16678 Suwon-si (KR)
(74) Representative: Marks & Clerk LLP

(57) **Abstract**

An energy storage system includes a battery module including a plurality of battery cells, a battery rack supporting the battery module, a detector configured to detect at least one of a change in temperature or a change in size of the battery module, and a fire extinguisher configured to spray a fire extinguishing agent on the battery module based on data detected from the detector

## Description

### BACKGROUND

### 1. Field

Aspects of embodiments of the present disclosure relate to an energy storage system.

### 2. Description of the Related Art

In general, an energy storage system or energy storage device (ESS) is a system capable of storing surplus electricity or electricity produced using renewable energy. Power supply and demand may be smoothly controlled by storing idle electric power during periods of low electricity demand and then supplying the electricity during periods of high electricity demand using the ESS.

In a space or facility where the ESS is installed and operated, equipment for suppressing battery fires caused by an electric shock, a short circuit, an external surge, or the like, may have to be mandatorily installed. A general fire extinguishing system may include a fire detection sensor, a sprinkler installed around a battery rack or on a ceiling, a fire extinguishing agent sprayer, and the like.

As an energy density of batteries is increased, amounts of flame and ejection pressure at vents of battery cells are increased, making it difficult to extinguish or suppress fires early with general fire suppression equipment. Therefore, a demand for an ESS fire extinguishing system capable of effectively suppressing multiple battery fires and extinguishing a high-pressure fire early in the event of the fire is increasing.

The above-described information disclosed in the technology that forms the background of the present disclosure is provided to improve understanding of the background of the present disclosure, and thus may include information that does not constitute the related art.

### SUMMARY

According to an aspect of embodiments of the present disclosure, an energy storage system capable of extinguishing a fire at an early stage by automatically operating a fire extinguishing system when an abnormal state of a battery cell is detected is provided.

The above and other aspects and features of the present disclosure will be described in or will be apparent from the following description of some embodiments of the present disclosure.

According to one or more embodiments, an energy storage system includes a battery module including a plurality of battery cells, a battery rack supporting the battery module, a detector configured to detect at least one of a change in temperature or a change in size of the battery module, and a fire extinguisher configured to spray a fire extinguishing agent on the battery module based on data detected from the detector.

The battery rack may include a rack frame on which the detector and the fire extinguisher are arranged, and a rack support on the rack frame and supporting the battery module.

The rack frame may include an upper frame, a lower frame below the upper frame, and a connection frame connecting the upper frame and the lower frame.

The detector may be mounted on at least one of the battery rack and a housing in which the battery rack is arranged.

The detector may include at least one of a temperature sensor to detect a temperature of the battery module and a size sensor to detect a size of the battery module.

The temperature sensor may be configured to measure a temperature of each of the plurality of battery cells.

The temperature sensor may include a temperature support mounted on the battery rack and located above the battery module, and a thermal imaging camera on the temperature support and configured to photograph the battery module.

The size sensor may be mounted on the battery rack and configured to photograph the size of the battery module.

The size sensor may be configured to detect a position of an outer surface of the battery module.

The energy storage system may further include a housing accommodating the battery rack, and the size sensor may be mounted on the housing to photograph a size of the battery rack.

The fire extinguisher may include a fire extinguishing tank in which a fire extinguishing agent is stored, a fire extinguishing pipe connected to the fire extinguishing tank and configured to guide the fire extinguishing agent, and a fire extinguishing nozzle on the fire extinguishing pipe and configured to spray the fire extinguishing agent on the battery module.

The fire extinguishing pipe may include a first pipe connected to the fire extinguishing tank, a second pipe extending from the first pipe and mounted on the battery rack, and a third pipe connected to the second pipe and extending toward a plurality of battery modules vertically arranged inside the battery rack.

The fire extinguishing nozzle may include a nozzle pipe branching from the third pipe toward the battery module and a nozzle outlet located in the nozzle pipe and configured to open and close the nozzle pipe to discharge the fire extinguishing agent to the battery modules.

The nozzle pipe may extend in a direction perpendicular to the third pipe, and the nozzle outlet may be located at an end of the nozzle pipe.

The fire extinguishing nozzle may include a plurality of additional pipes extending in an inclined direction along a circumferential surface of the nozzle pipe, and additional outlets located in the plurality of additional pipes and configured to open and close the additional pipes to discharge the fire extinguishing agent to the battery module.

The nozzle pipe may be rotatable in an axial direction.

The energy storage system according to the present disclosure may further include an alarm configured to generate an alarm sound based on data detected from the detector.

The alarm may be operated when a temperature of the plurality of battery cells or the battery module detected from the detector reaches a first temperature, and the fire extinguisher may be operated when the temperature of the plurality of battery cells or the battery module detected from the detector reaches a second temperature.

The alarm may be operated when a size of the battery module or the battery rack detected from the detector reaches a first size, and the fire extinguisher may be operated when the size of the battery module or the battery rack detected from the detector reaches a second size.

The energy storage system according to the present disclosure may further include an additional detector configured to detect at least one of a voltage, a current, or a capacity of the plurality of battery cells or the battery module and induce an operation of the fire extinguisher.

At least some of the above and other features of the invention are set out in the claims.

### BRIEF DESCRIPTION OF THE DRAWINGS

The drawings attached to this specification illustrate some embodiments of the present disclosure, and further describe aspects and features of the present disclosure together with the detailed description of the present disclosure. However, the present disclosure is not to be construed as being limited to the drawings.
FIG. 1 is a diagram schematically showing an energy storage system according to an embodiment of the present disclosure;
FIG. 2 is a diagram schematically showing a battery rack according to an embodiment of the present disclosure;
FIG. 3 is a diagram schematically showing a state in which a detection unit detects a temperature according to an embodiment of the present disclosure;
FIG. 4 is a diagram schematically showing a state in which the detection unit detects a size or position according to an embodiment of the present disclosure;
FIG. 5 is a diagram schematically showing a fire extinguishing unit according to an embodiment of the present disclosure;
FIG. 6 is a diagram schematically showing a fire extinguishing nozzle according to an embodiment of the present disclosure;
FIG. 7 is a diagram schematically showing a state in which an alarm unit is included in the energy storage system of FIG. 1; and
FIG. 8 is a diagram schematically showing a state in which an additional detection unit is included in the energy storage system of FIG. 1.

### DETAILED DESCRIPTION

Herein, some embodiments of the present disclosure will be described, in further detail, with reference to the accompanying drawings. The terms or words used in this specification and claims are not to be construed as being limited to the usual or dictionary meaning and should be interpreted as having a meaning and concept consistent with the technical idea of the present disclosure based on the principle that the inventor can be his/her own lexicographer to appropriately define the concept of the term.

The embodiments described in this specification and the configurations shown in the drawings are provided as some example embodiments of the present disclosure and do not necessarily represent all of the technical ideas, aspects, and features of the present disclosure. Accordingly, it is to be understood that there may be various equivalents and modifications that may replace or modify the embodiments described herein at the time of filing this application.

It is to be understood that when an element or layer is referred to as being "on," "connected to," or "coupled to" another element or layer, it may be directly on, connected, or coupled to the other element or layer, or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element, or the first element may be indirectly coupled or connected to the second element via one or more intervening elements.

In the figures, dimensions of the various elements, layers, etc. may be exaggerated for clarity of illustration. The same reference numerals designate the same or like elements. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. When phrases such as "at least one of A, B, and C," "at least one of A, B, or C," "at least one selected from a group of A, B, and C," or "at least one selected from among A, B, and C" are used to designate a list of elements A, B, and C, the phrase may refer to any and all suitable combinations or a subset of A, B, and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It is to be understood that, although the terms "first," "second," "third," etc. may be used herein to describe various elements, components, regions, layers, and/or sections, these elements, components, regions, layers, and/or sections are not to be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It is to be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (e.g., rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It is to be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all sub-ranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, applicant reserves the right to amend this specification, including the claims, to expressly recite any sub-range subsumed within the ranges expressly recited herein.

References to two compared elements, features, etc. as being "the same" may mean that they are the same or substantially the same. Thus, the phrase "the same" or "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or plural.

When an arbitrary element is referred to as being arranged (or located or positioned) on the "above (or below)" or "on (or under)" a component, it may mean that the arbitrary element is placed in contact with the upper (or lower) surface of the component and may also mean that another component may be interposed between the component and any arbitrary element arranged (or located or positioned) on (or under) the component.

In addition, it is to be understood that when an element is referred to as being "coupled," "linked," or "connected" to another element, the elements may be directly "coupled," "linked," or "connected" to each other, or one or more intervening elements may be present therebetween, through which the element may be "coupled," "linked," or "connected" to another element. In addition, when a part is referred to as being "electrically coupled" to another part, the part may be directly electrically connected to another part, or one or more intervening parts may be present therebetween such that the part and the other part are indirectly electrically connected to each other.

Throughout the specification, when "A and/or B" is stated, it means A, B, or A and B, unless otherwise stated. That is, "and/or" includes any or all combinations of a plurality of items enumerated. When "C to D" is stated, it means C or more and D or less, unless otherwise specified.

The terms used in the present specification are for describing embodiments of the present disclosure and are not intended to limit the present disclosure.

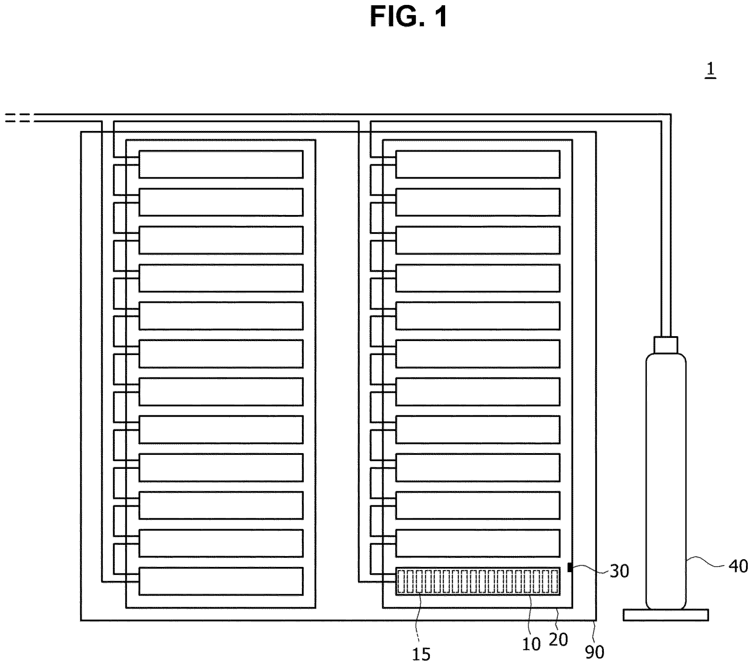

FIG. 1 is a diagram schematically showing an energy storage system according to an embodiment of the present disclosure. Referring to FIG. 1, an energy storage system 1 according to the present embodiment includes a battery module 10, a battery rack 20, a detection unit, or detector, 30, and a fire extinguishing unit, or fire extinguisher, 40.

The battery module 10 may include a plurality of battery cells 15. In an embodiment, the battery module 10 may contain the plurality of battery cells 15 inside a case that has a generally hexahedral shape. Each battery cell 15 may be arranged at a certain distance from other battery cells 15. The battery cells 15 may be arranged in a row to correspond to a size of the battery module 10. The battery cell 15 may be a secondary battery capable of charging and discharging.

The battery rack 20 may support the battery module 10. In an embodiment, the battery rack 20 may be made of a metal and may have a sheet of flame-retardant material attached thereto. In an embodiment, the battery rack 20 may have a generally rectangular parallelepiped shape.

The detection unit 30 may detect at least one of a change in temperature and a change in size of the battery module 10. The detection unit 30 may be mounted on the battery rack 20 or on a housing 90 in which the battery rack 20 is built or arranged.

The fire extinguishing unit 40 may spray a fire extinguishing agent on the battery module 10 based on data detected from the detection unit 30. The fire extinguishing unit 40 may be entirely built into the housing 90 or a portion thereof may be disposed outside the housing 90. The fire extinguishing agent may include one or more of argon, nitrogen, and carbon dioxide. When carbon dioxide is used as the fire extinguishing agent, carbon dioxide may be liquefied and stored at a low temperature and a high-pressure state.

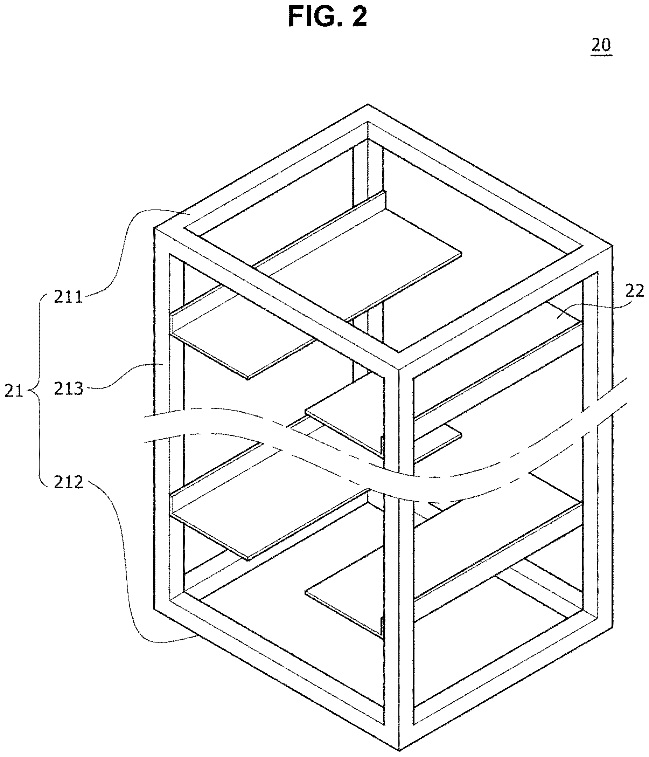

FIG. 2 is a diagram schematically showing the battery rack according to an embodiment of the present disclosure. Referring to FIG. 2, the battery rack 20 may include a rack frame 21 and a rack support 22.

In an embodiment, the detection unit 30 and the fire extinguishing unit 40 may be selectively disposed on the rack frame 21. In an embodiment, the rack frame 21 may form a rectangular parallelepiped frame. The rack frame 21 may include an upper frame 211, a lower frame 212 disposed below the upper frame 211, and a connection frame 213 connecting the upper frame 211 and the lower frame 212.

The rack support 22 may be formed on the rack frame 21 and may support the battery module 10. In an embodiment, a plurality of rack supports 22 may be arranged to be spaced apart in a vertical direction of the connection frame 213, and a pair of rack supports 22 may be arranged to face each other at a same height to support a plurality of battery modules 10 along a vertical direction.

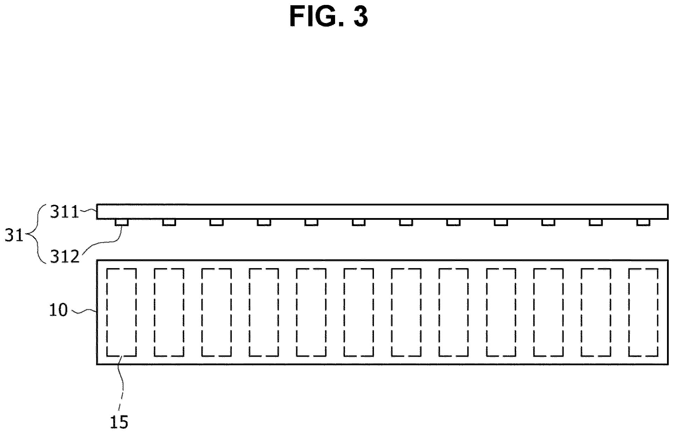

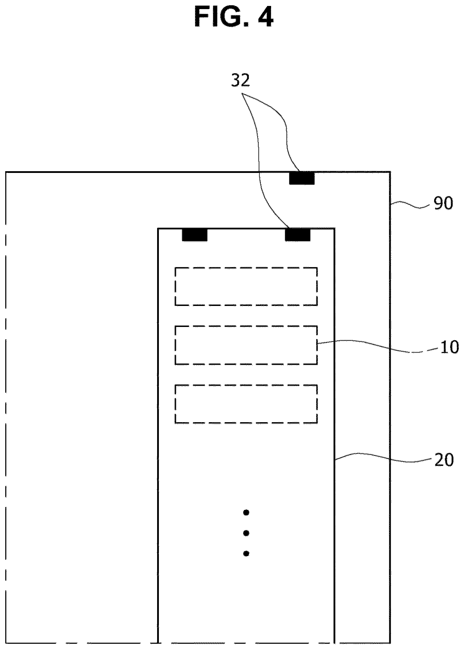

FIG. 3 is a diagram schematically showing a state in which the detection unit detects a temperature according to an embodiment of the present disclosure; and FIG. 4 is a diagram schematically showing a state in which the detection unit detects a size or position according to an embodiment of the present disclosure. Referring to FIGS. 3 and 4, in the present embodiment, the detection unit 30 may include a temperature sensor 31 and a size sensor 32.

The temperature sensor 31 may detect the temperature of the battery module 10. The temperature sensor 31 may measure the temperature of each battery module 10. The temperature sensor 31 may include a temperature support 311 mounted on the battery rack 20 and disposed above or on a side of the battery module 10, and a thermal imaging camera 312 formed or arranged on the temperature support 311 and configured to detect the temperature by photographing the battery module 10. In an embodiment, the temperature sensor 31 may measure the temperature of each of the plurality of battery cells 15.

The size sensor 32 may detect the size or position of the battery module 10. The size sensor 32 may be mounted on the battery rack 20, and may detect expansion of the battery module 10 by photographing the size of the battery module 10. When the size of the battery module 10 expands due to an abnormality in the battery cell 15, the size sensor 32 may detect the expansion. The size sensor 32 may detect the position of an outer surface of the battery module 10. The fire extinguishing unit 40 may spray a fire extinguishing agent based on receiving a detection signal from the size sensor 32 when the size of the battery module 10 reaches a certain size (e.g., a set size) or a certain position (e.g., a set position).

In an embodiment, the size sensor 32 may be mounted on the housing 90 in which the battery rack 20 is provided, and may detect expansion of the battery rack 20 by photographing the size of the battery rack 20. In an embodiment, when the battery module 10 is in close contact with the battery rack 20 depending on a design environment, the battery rack 20 itself may be deformed and expanded due to being pushed by the battery module 10 when the battery module 10 is intermittently expanded, and the size sensor 32 mounted on the housing 90 may detect deformation of the battery rack 20. In addition, the size sensor 32 mounted on the housing 90 may detect a position of an outer surface of the battery rack 20. The fire extinguishing unit 40 may spray a fire extinguishing agent based on receiving a detection signal from the size sensor 32 when the size of the battery rack 20 reaches a certain size (e.g., a set size) or a certain position (e.g., a set position).

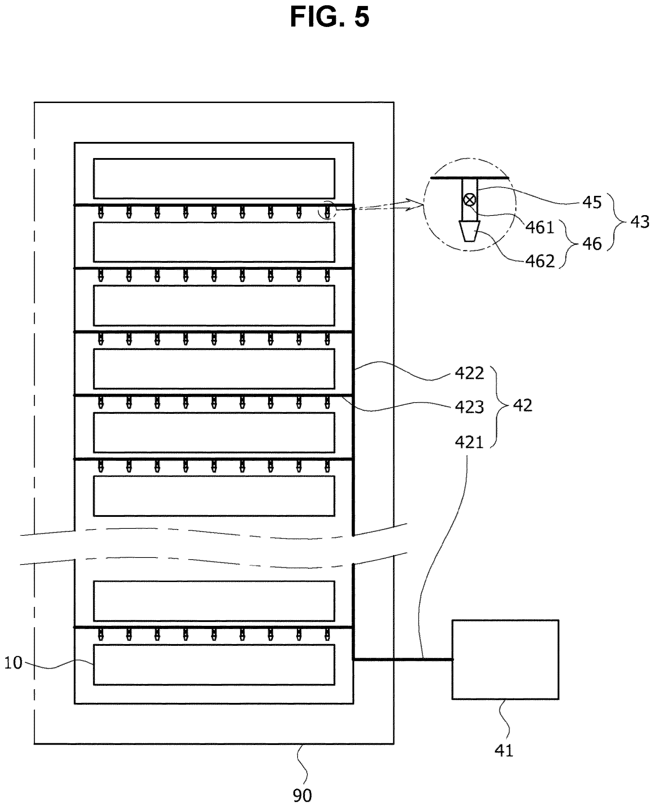

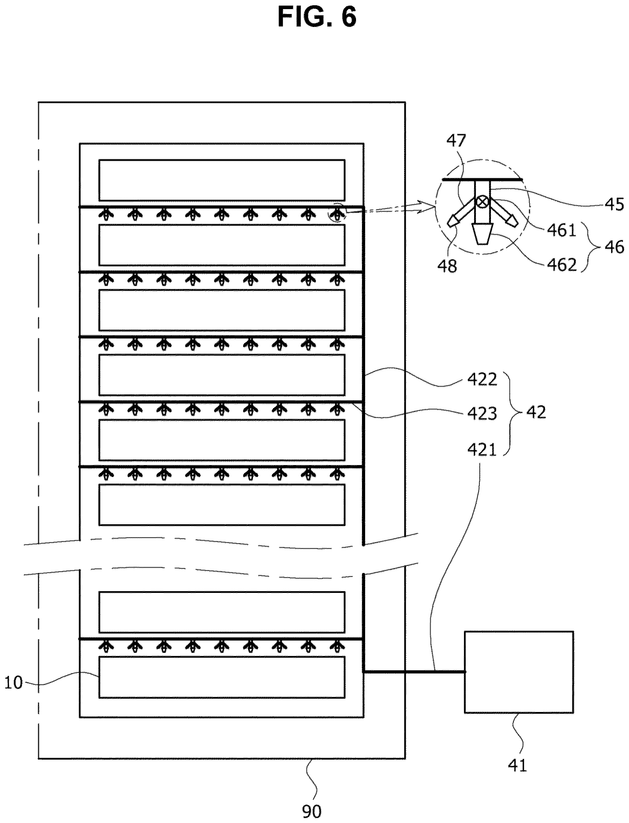

FIG. 5 is a diagram schematically showing the fire extinguishing unit according to an embodiment of the present disclosure; and FIG. 6 is a diagram schematically showing a fire extinguishing nozzle according to an embodiment of the present disclosure. Referring to FIGS. 5 and 6, in the present embodiment, the fire extinguishing unit 40 may include a fire extinguishing tank 41, a fire extinguishing pipe 42, and a fire extinguishing nozzle 43.

A fire extinguishing agent may be stored in the fire extinguishing tank 41. The fire extinguishing tank 41 may be stored inside the housing 90 or may be disposed outside the housing 90.

The fire extinguishing pipe 42 may be connected to the fire extinguishing tank 41 to guide the fire extinguishing agent. In an embodiment, the fire extinguishing pipe 42 may be mounted on the battery rack 20, and may be disposed above the battery module 10. In an embodiment, the fire extinguishing pipe 42 may include a first pipe 421, a second pipe 422, and a third pipe 423. The first pipe 421 may be connected to the fire extinguishing tank 41. The second pipe 422 may extend from the first pipe 421, and may be fixedly installed in the housing 90 or the battery rack 20. The third pipe 423 may be connected to the second pipe 422, and may extend toward the plurality of battery modules 10 vertically arranged inside the battery rack 20. In an embodiment, a plurality of third pipes 423 may be branched in a longitudinal direction of the second pipe 422, and may be respectively disposed above the battery modules 10.

The fire extinguishing nozzle 43 may be formed or arranged on the fire extinguishing pipe 42, and may spray the fire extinguishing agent on the battery module 10. In an embodiment, a plurality of fire extinguishing nozzles 43 may be arranged in a longitudinal direction of the third pipe 423 to respond to fires in the battery module 10 that occur at various points or locations.

In the present embodiment, the fire extinguishing nozzle 43 may include a nozzle pipe 45 and a nozzle outlet 46.

The nozzle pipe 45 may branch from the third pipe 423 toward the battery module 10. A plurality of nozzle pipes 45 may be arranged at intervals (e.g., equal intervals) in the longitudinal direction of the third pipe 423. In an embodiment, the nozzle pipes 45 may be arranged to correspond to a size or shape of the battery module 10.

The nozzle outlet 46 may be formed in the nozzle pipe 45, and may open and close the nozzle pipe 45 to discharge the fire extinguishing agent to the battery module 10. In an embodiment, the nozzle outlet 46 may include a pipe valve 461 that opens and closes the nozzle pipe 45 according to an electrical signal, and a pipe duct 462 formed at an end of the nozzle pipe 45 to guide the fire extinguishing agent for intensive spraying of the spurting fire extinguishing agent.

In an embodiment, the nozzle pipe 45 may extend in a direction perpendicular to the third pipe 423, and the nozzle outlet 46 may be formed or arranged at an end of the nozzle pipe 45. The nozzle outlet 46 may be assembled to the end of the nozzle pipe 45. The pipe valve 461 may be built into the pipe duct 462 to open and close the pipe duct 462. The pipe duct 462 may be manufactured in any of various shapes depending on a direction and method of spraying the fire extinguishing agent, and the pipe duct 462 may be replaced depending on an installation environment.

In an embodiment, as shown in FIG. 6, the fire extinguishing nozzle 43 may further include an additional pipe 47 and an additional outlet 48.

In an embodiment, a plurality of additional pipes 47 may extend in an inclined direction along a circumferential surface of the nozzle pipe 45. The additional pipes 47 may be formed integrally with the nozzle pipe 45 or may be joined by welding, for example.

The additional outlet 48 may be formed in each of the plurality of additional pipes 47, and may discharge the fire extinguishing agent to the battery module 10 by opening and closing the additional pipe 47. In an embodiment, the additional outlet 48 may be configured to have a same shape and configuration as the nozzle outlet 46 and differ from the nozzle outlet 46 only in an arrangement structure, and a further detailed description thereof will be omitted.

In an embodiment, the nozzle pipe 45 may be rotatable in an axial direction. In an embodiment, the nozzle pipe 45 may be rotated by driving of a motor, and a spray point of the fire extinguishing agent discharged through the nozzle outlet 46 and the additional outlet 48 in conjunction with the nozzle pipe 45 may vary. Thereby, the nozzle pipe 45 may be rotated such that the fire extinguishing agent is sprayed on an exact fire point.

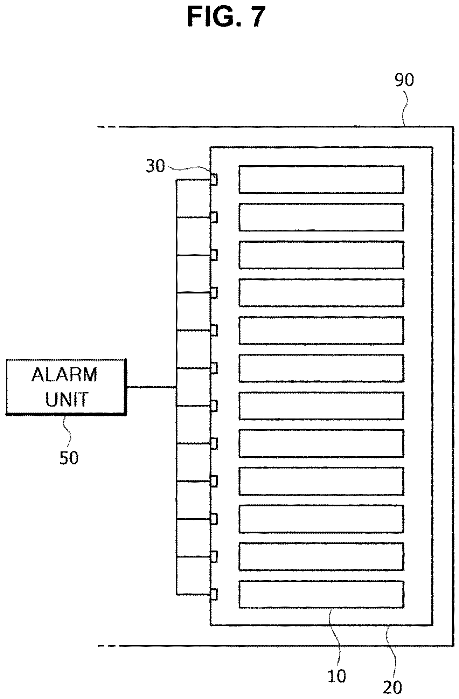

FIG. 7 is a diagram schematically showing a state in which an alarm unit, or alarm, is included in the energy storage system of FIG. 1. Referring to FIG. 7, the energy storage system 1 according to an embodiment of the present disclosure may further include an alarm unit, or alarm, 50. The alarm unit 50 may generate an alarm sound based on data detected from the detection unit 30. In an embodiment, the alarm unit 50 may be mounted on the housing 90 or in a situation room for managing the energy storage system 1. The alarm unit 50 may be connected to the detection unit 30 wirelessly or by wire. The alarm unit 50 may receive a detection signal from the detection unit 30 and generate the alarm sound through an algorithm of the alarm unit 50. In addition, a controller that receives the detection signal from the detection unit 30 may control an operation of the alarm unit 50.

In an embodiment, when the temperature of the plurality of battery cells 15 or the battery module 10 detected from the detection unit 30 reaches a first set temperature, the alarm unit 50 may be operated. The first set temperature may be a temperature out of a temperature range for stable operation due to an abnormal operation of the battery cells 15 or the battery module 10. The controller may operate the alarm unit 50 such that a worker or manager recognizes information that the first set temperature is reached through an algorithm of the alarm unit 50.

In an embodiment, when the temperature of the battery cells 15 or the battery module 10 detected from the detection unit 30 reaches a second set temperature, the fire extinguishing unit 40 may be operated. In an embodiment, the second set temperature may be a temperature before (e.g., just before) explosion of the battery cell 15 or the battery module 10. The controller may automatically operate the fire extinguishing unit 40 to prevent or substantially prevent explosion or spread of fire when the second set temperature is reached through an algorithm of the controller. The fire extinguishing unit 40 may spray the fire extinguishing agent intensively on the battery module 10 that reaches the second set temperature.

In an embodiment, when the size of the battery module 10 or the battery rack 20 detected from the detection unit 30 reaches a first set size, the alarm unit 50 may be operated. The first set size may be a state in which the shape of the battery module 10 or the battery rack 20 expands beyond a designed value due to an abnormal operation of the battery cell 15 or the battery module 10. The controller may operate the alarm unit 50 through an algorithm of the controller such that a worker or manager may recognize information that the first set size is reached.

When the size of the battery module 10 or the battery rack 20 detected from the detection unit 30 reaches a second set size, the fire extinguishing unit 40 may be operated. The second set size may be a size before (e.g., just before) the battery cell 15 or the battery module 10 expands and explodes. The controller may automatically operate the fire extinguishing unit 40 to prevent or substantially prevent explosion or spread of fire when the second set size is reached through an algorithm of the controller. The fire extinguishing unit 40 may spray the fire extinguishing agent intensively on the battery module 10 that reaches the second set size.

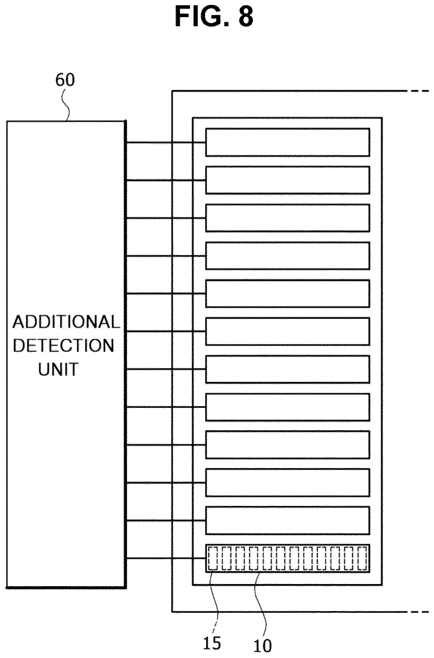

FIG. 8 is a diagram schematically showing a state in which an additional detection unit is included in the energy storage system of FIG. 1. Referring to FIG. 8, the energy storage system 1 according to an embodiment of the present disclosure may further include an additional detection unit, or additional detector, 60.

The additional detection unit 60 may detect at least one of a voltage, a current, and a capacity of the plurality of battery cells 15 or the battery module 10 and induce the operation of the fire extinguishing unit 40. The additional detection unit 60 may induce the operation of the fire extinguishing unit 40 when an abnormal voltage, current, or capacity value of the battery cells 15 or the battery module 10 is detected when the energy storage system 1 operates or when the energy storage system 1 is at rest. Thereby, explosion or ignition of the battery cells 15 or the battery module 10 may be suppressed in advance.

As a first example, when a voltage value of the battery cells 15 or the battery module 10 measured by the additional detection unit 60 is outside of a certain voltage range (e.g., a set voltage range), the controller may operate the fire extinguishing unit 40. For example, when the voltage value measured by the additional detection unit 60 is 0.05 V higher or lower than the certain voltage range (e.g., the set voltage range), the fire extinguishing unit 40 may be operated.

As a second example, when a current value of the battery cells 15 or the battery module 10 measured by the additional detection unit 60 is outside of a certain current range (e.g., a set current range), the controller may operate the fire extinguishing unit 40. For example, when the current value measured by the additional detection unit 60 is 10 A higher or lower than the certain current range (e.g., the set current range), the fire extinguishing unit 40 may be operated.

As a third example, when a capacity value of the battery cells 15 or the battery module 10 measured by the additional detection unit 60 is outside of a certain capacity range (e.g., a set capacity range), the controller may operate the fire extinguishing unit 40. For example, when the capacity value measured by the additional detection unit 60 in the battery cells 15 becomes 110% of the certain capacity range (e.g., the set capacity range) or becomes lower than the certain capacity range (e.g., the set capacity range), the fire extinguishing unit 40 may be operated. For example, when the capacity value measured by the additional detection unit 60 in the battery module 10 reaches 110% of the certain capacity range (e.g., the set capacity range), the fire extinguishing unit 40 may be operated.

As a fourth example, when there is no amount of change in voltage, the fire extinguishing unit 40 may be operated when the voltage of the battery cell 15 measured by the additional detection unit 60 is 200 mV for three minutes. At this time, the battery module 10 may reflect a series-parallel voltage value.

As a fifth example, when the amount of change in voltage is small, the fire extinguishing unit 40 may be operated when the voltage of the battery cell 15 measured by the additional detection unit 60 reaches 100 mV. At this time, the battery module 10 may reflect a series-parallel voltage value.

As a sixth example, when the amount of change in capacity is small, the fire extinguishing unit 40 may be operated when the capacity of the battery cells 15 and the battery module 10 measured by the additional detection unit 60 becomes 5% greater or smaller than the capacity of the battery cells 15 and the battery module 10.

In an energy storage system according to one or more embodiments of the present disclosure, a detection unit can detect a change in temperature or a change in size of a battery module, and a fire extinguishing unit can spray a fire extinguishing agent based on data detected from the detection unit, thereby suppressing explosion or fire of the battery module.

In the energy storage system according to one or more embodiments of the present disclosure, a size sensor can detect a size or position of a battery module or photograph the size or position of a battery rack, thereby determining whether the battery rack is abnormally expanded.

In the energy storage system according to one or more embodiments of the present disclosure, a fire extinguishing agent stored in a fire extinguishing tank can be moved through a fire extinguishing pipe and sprayed on a battery module through a fire extinguishing nozzle, thereby suppressing fire or explosion of the battery module.

In the energy storage system according to one or more embodiments of the present disclosure, since a nozzle pipe discharges a fire extinguishing agent vertically downward and an additional pipe extends in an inclined direction along a circumferential surface of the nozzle pipe to radially discharge the fire extinguishing agent, the fire extinguishing agent can be concentrated and discharged at various fire points in a battery module.

However, aspects and effects obtainable through the present disclosure are not limited to the above aspects and effects, and other technical aspects and effects that are not mentioned will be clearly understood by those skilled in the art from the following description of the present disclosure.

While the present disclosure has been described with reference to some embodiments shown in the drawings, these embodiments are merely illustrative and it is to be understood that various modifications and equivalent other embodiments can be derived by those skilled in the art on the basis of the embodiments.

Therefore, the technical scope of the present disclosure should be defined by the claims.

## Claims

1. An energy storage system comprising:
a battery module comprising a plurality of battery cells;
a battery rack supporting the battery module;
a detector configured to detect at least one of a change in temperature or a change in size of the battery module; and
a fire extinguisher configured to spray a fire extinguishing agent on the battery module based on data detected from the detector.

2. The energy storage system as claimed in claim 1, wherein the battery rack comprises:
a rack frame on which the detector and the fire extinguisher are arranged; and
a rack support on the rack frame and supporting the battery module.

3. The energy storage system as claimed in claim 2, wherein the rack frame comprises:
an upper frame;
a lower frame below the upper frame; and
a connection frame connecting the upper frame and the lower frame.

4. The energy storage system as claimed in claim 1, 2 or 3, wherein the detector is mounted on at least one of the battery rack and a housing in which the battery rack is arranged.

5. The energy storage system as claimed in any preceding claim, wherein the detector comprises at least one of:
a temperature sensor to detect a temperature of the battery module; and
a size sensor to detect a size of the battery module.

6. The energy storage system as claimed in claim 5, wherein the temperature sensor comprises:
a temperature support mounted on the battery rack and located above the battery module; and
a thermal imaging camera on the temperature support and configured to photograph the battery module.

7. The energy storage system as claimed in claim 5 or 6, wherein the size sensor is mounted on the battery rack and is configured to photograph the size of the battery module.

8. The energy storage system as claimed in claim 5 or 6, further comprising a housing accommodating the battery rack,
wherein the size sensor is mounted on the housing to photograph a size of the battery rack.

9. The energy storage system as claimed in any preceding claim, wherein the fire extinguisher comprises:
a fire extinguishing tank in which a fire extinguishing agent is stored;
a fire extinguishing pipe connected to the fire extinguishing tank and configured to guide the fire extinguishing agent; and
a fire extinguishing nozzle on the fire extinguishing pipe and configured to spray the fire extinguishing agent on the battery module.

10. The energy storage system as claimed in claim 9, wherein the fire extinguishing pipe comprises:
a first pipe connected to the fire extinguishing tank;
a second pipe extending from the first pipe and mounted on the battery rack; and
a third pipe connected to the second pipe and extending toward a plurality of battery modules vertically arranged inside the battery rack.

11. The energy storage system as claimed in claim 10, wherein the fire extinguishing nozzle comprises:
a nozzle pipe branching from the third pipe toward the battery module; and
a nozzle outlet located in the nozzle pipe and configured to open and close the nozzle pipe to discharge the fire extinguishing agent to the plurality of battery modules.

12. The energy storage system as claimed in any preceding claim, further comprising an alarm configured to generate an alarm sound based on data detected from the detector.

13. The energy storage system as claimed in claim 12, wherein the alarm is operated when a temperature of the plurality of battery cells or the battery module detected from the detector reaches a first temperature, and
the fire extinguisher is operated when the temperature of the plurality of battery cells or the battery module detected from the detector reaches a second temperature.

14. The energy storage system as claimed in claim 12 or 13, wherein the alarm is operated when a size of the battery module or the battery rack detected from the detector reaches a first size, and
the fire extinguisher is operated when the size of the battery module or the battery rack detected from the detector reaches a second size.

15. The energy storage system as claimed in any preceding claim, further comprising an additional detector configured to detect at least one of a voltage, a current, or a capacity of the plurality of battery cells or the battery module and induce an operation of the fire extinguisher.
